**Europäisches Patentamt**

**European Patent Office**

**Office européen des brevets**

(11) Veröffentlichungsnummer: **0 195 992**
**A2**

(12) **EUROPÄISCHE PATENTANMELDUNG**

(21) Anmeldenummer: **86103529.3**

(22) Anmeldetag: **15.03.86**

(51) Int. Cl.⁴: **B29C 31/00** , B29C 67/18 ,
G03F 7/16

(30) Priorität: 26.03.85 DE 3510852

(43) Veröffentlichungstag der Anmeldung:
**01.10.86 Patentblatt 86/40**

(84) Benannte Vertragsstaaten:
**AT BE CH DE FR GB IT LI NL SE**

(71) Anmelder: **HOECHST AKTIENGESELLSCHAFT**
**Postfach 80 03 20**
**D-6230 Frankfurt am Main 80(DE)**

(72) Erfinder: **Kühnert, Hans-Günter Egbert**
**Lerchenweg 8**
**D-6106 Erzhausen(DE)**

(54) **Greifereinrichtung in einer Laminiervorrichtung.**

(57) Die Greifereinrichtung 1 weist zumindest zwei Vakuum-greifer 8,8 auf, die entlang einer Querstrebe 13 der Greife-reinrichtung horizontal verschiebbar und festlegbar sind. Die Greifereinrichtung ist vertikal auf und ab verfahrbar und enthält ein sich über die Breite der Querstrebe erstreckendes Blasrohr 6, aus dem ein Luftstrom austritt, der den festzuhal-tenden und zu transportierenden Fotoresistfilm 24 mit seiner fotoresistfreien Rückseite gegen die Vakuumgreifer 8,8 drückt. Sobald diese mit Vakuum beaufschlagt sind, wird der Fotoresistfilm festgehalten und nach unten transportiert. Auf der Oberseite des Blasrohrs 6 sind Anschlagschrauben 14,15 angeordnet, die beim Hochfahren der Greifereinrichtung an der Unterseite von vertikal verschiebbaren Befestigungselementen 16,17, an denen eine Schneidleiste 7 mit einer Schneidnut 20 befestigt ist, anliegen. Beim Hochfahren der Greifereinrichtung wird die Schneidleiste 7 mithochgenom-men, wobei der Fotoresistfilm 24 durch die Abschrägung der Schneidleiste von der Saugplatte 23, die unter Vakuum steht, abgehoben wird.

FIG. 3

Greifereinrichtung in einer Laminiervorrichtung

Die Erfindung betrifft eine Greifereinrichtung in einer Laminiervorrichtung, mit einer verfahrbaren Greiferleiste zum Festhalten und Transportieren eines auf einen Schichtträger aufzulaminierenden Films, den eine Schneideinrichtung jeweils auf eine vorgegebene Länge zuschneidet.

Vor dem Laminieren von Schichtträgern, wie Leiterplatten, Multilayerschichten, Metallplatten oder Substraten mit beidseitig aufgedampften und/oder aufgeklebten Metallschichten, mit einem Fotoresistfilm, wird dieser faltenfrei auf horizontal oder vertikal ausgerichteten Saugplatten von Vakuumtischen aufgespannt und auf das gewünschte Format geschnitten, das für ein deckungsgleiches Auflaminieren des Fotoresistfilms auf den jeweiligen Schichtträger erforderlich ist.

Aus den offengelegten europäischen Patentanmeldungen 0 040 842, 0 040 843 und 0 041 642 sind Laminiervorrichtungen bekannt, bei denen ein Substrat bzw. ein Schichtträger beidseitig unter Druckanwendung mit einem Trockenresist laminiert wird. Der Trockenresist wird für die jeweils zu laminierende Seite des Schichtträgers, beispielsweise eine Leiterplatte, von einer Vorratsrolle abgezogen und einem Paar von Laminierwalzen zugeführt, durch deren Spalt die beiden Trockenresistfilme und der dazwischen befindliche Schichtträger hindurchlaufen.

In der deutschen Patentanmeldung P 34 20 429.6 wird zum Festhalten und Transportieren eines Fotoresistfilms über die Saugplatte eines Vakuumtisches eine verfahrbare Greiferleiste vorgeschlagen, die über eine flexible Vakuumleitung mit einer Vakuumpumpe verbunden ist. Die Greiferleiste ist mit zwei Führungen verbunden, die entlang von Führungsstangen mit Hilfe einer Antriebskette verschiebbar sind. Ein streifenförmiger Abschnitt des Fotoresistfilms wird von der hochgefahrenen Greiferleiste erfaßt und nach unten transportiert. Der Fotoresistfilm überspannt dann einen oberen Vakuumtisch, den Spalt der Laminierstation und einen unteren Vakuumtisch, wobei die gesamte Länge an aufgespanntem Fotoresistfilm der Größe der zu laminierenden Plattenflächen entspricht. In den beiden Vakuumtischen ist ein Vakuum aufgebaut, so daß der Fotoresistfilm faltenfrei über die Saugplatten der Vakuumtische hinweggeführt werden kann. Sobald die Greiferleiste ihre Endposition erreicht hat, bleiben die Vakuumtische mit Saugluft beaufschlagt und dadurch der Fotoresistfilm faltenfrei auf den Saugplatten der Vakuumtische aufgespannt. Bei dieser vorgeschlagenen Greifereinrichtung erfaßt die Greiferleiste die Fotoresistschicht des Fotoresistfilms, wodurch es zu Eindrücken auf dieser Schicht kommen kann, verursacht durch das Vakuum, mit dem die Greiferleiste beaufschlagt ist. Daneben kann es durch die mechanische Einwirkung der Greiferleiste auf die Fotoresistschicht, falls diese durch längere Lagerung leicht versprödet ist, zu feinen Absplitterungen in der Fotoresistschicht kommen. Sowohl die durch die Greiferleiste in der Fotoresistschicht bewirkten Eindrücke als auch die Absplitterungen von Fotoresistmaterial beeinträchtigen offensichtlich die Qualität der Fotoresistschicht, was keiner näheren Erläuterungen bedarf.

Aufgabe der Erfindung ist es, eine Greifereinrichtung der eingangs beschriebenen Art so zu verbessern, daß eine Beschädigung der Fotoresistschicht beim Erfassen und Transportieren des Fotoresistfilms weitgehend vermieden wird.

Die Aufgabe wird erfindungsgemäß dadurch gelöst, daß die Greifereinrichtung zumindest zwei Vakuumgreifer aufweist, die entlang einer Querstrebe der Greifereinrichtung horizontal verschiebbar und festlegbar sind, daß die Greifereinrichtung entlang vertikaler Führungsstangen auf und ab verfahrbar ist und ein oberhalb der Querstrebe sich über die Breite der Querstrebe erstreckkendes Blasrohr enthält, aus dessen Öffnungen ein Luftstrom in Richtung der Vakuumgreifer austritt und daß auf der Oberseite des Blasrohrs, in der Nähe der Stirnflächen des Blasrohrs Anschlagschrauben angeordnet sind, die beim Hochfahren der Greifereinrichtung an der Unterseite von vertikal verschiebbaren Befestigungselementen, an denen eine Schneidleiste befestigt ist, anliegen und diese beim Hochfahren der Greifereinrichtung auf der fotoresistfreien Rückseite des Films mithochnehmen.

In Ausgestaltung der Erfindung weisen die Vakuumgreifer Formbohrungen, die mit Vakuum beaufschlagbar sind, auf der von einer Saugplatte abgewandten Seite auf, während die der Saugplatte zugewandte Seite der Vakuumgreifer keine Formbohrungen hat und nahezu abstandslos an die Saugplatte angrenzt.

In weiterer Ausgestaltung der Erfindung ist die Schneidleiste nach oben hin und auf die Saugplatte zu abgeschrägt und liegt ein Film von oben her an der Saugplatte und der abgeschrägten Schneidleiste an, die den Film von der Saugplatte abhebt.

In Weiterbildung der Erfindung sind die Befestigungselemente, an denen die Schneidleiste angebracht ist, an den unteren Enden von Stangen befestigt, die in Linearführungen gleiten und sind die Linearführungen mit einer Traverse der lagefesten Schneideinrichtung verbunden.

Zweckmäßigerweise sind an den oberen Enden der Stangen Anschlagklötzchen befestigt, die sich oberhalb der Linearführungen befinden und die Abwärtsbewegung der Stangen in den Linearführungen begrenzen.

Um einen einwandfreien Schnitt des Films zu gewährleisten, enthält die Schneidleiste in einer Schneidebene eine Schneidnut, in die sich bzw. aus der sich ein in der Schneidebene horizontal hin und her verschiebbarer, beheizter Schneiddraht nach dem Durchschneiden des auf der Schneidleiste aufliegenden Films kurzfristig hinein und hinaus bewegt.

Zum Verstellen der Vakuumgreifer über die Breite des Films weist die Querstrebe einen waagerechten Schlitz auf, durch den sich Flügelschrauben erstrecken, die mit den Befestigungselementen im Eingriff sind, an denen die Vakuumgreifer befestigt sind.

Die Erfindung wird im folgenden anhand eines zeichnerisch dargestellten Ausführungsbeispiels näher erläutert.

Es zeigen:

Fig. 1 eine perspektivische Teilansicht der Greifereinrichtung nach der Erfindung,

Fig. 2 eine Seitenansicht im Schnitt der Greifereinrichtung und der Schneideinrichtung zu Beginn der Aufwärtsbewegung der Greiferleiste der Greifereinrichtung, und

Fig. 3 eine Seitenansicht im Schnitt ähnlich zu Fig. 2, mit hochgefahrener Greiferleiste, in einer Position, in der die Rückseite des Films von der Greiferleiste festgehalten und die Abwärtsbewegung der Greiferleiste beginnt.

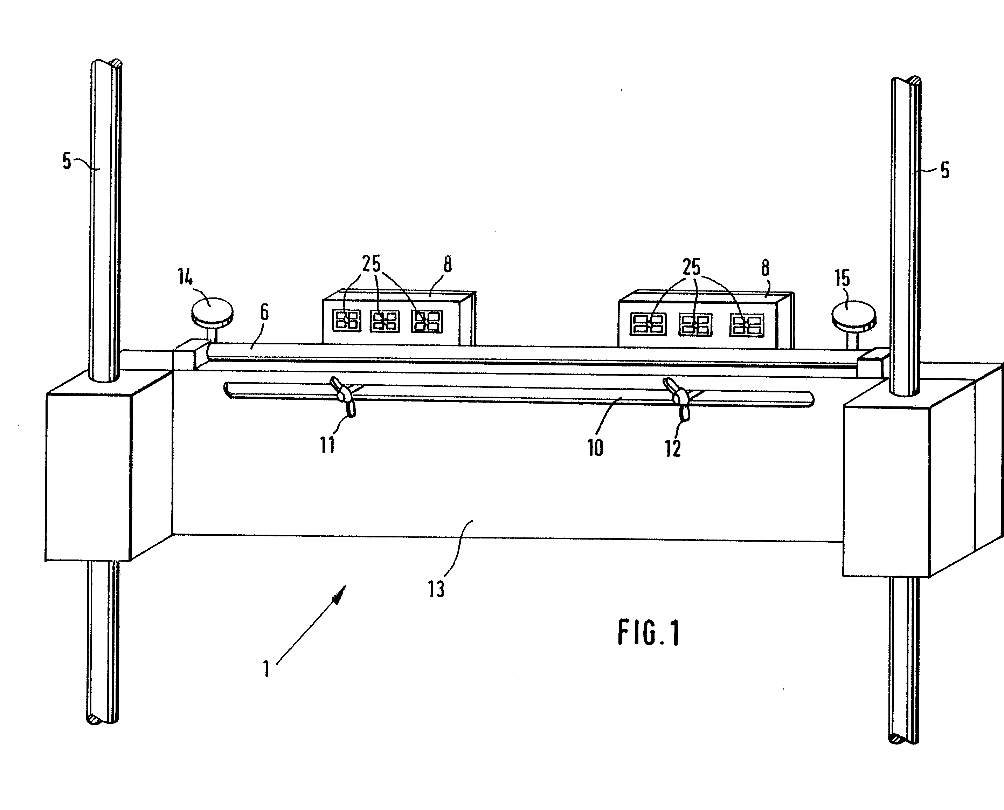

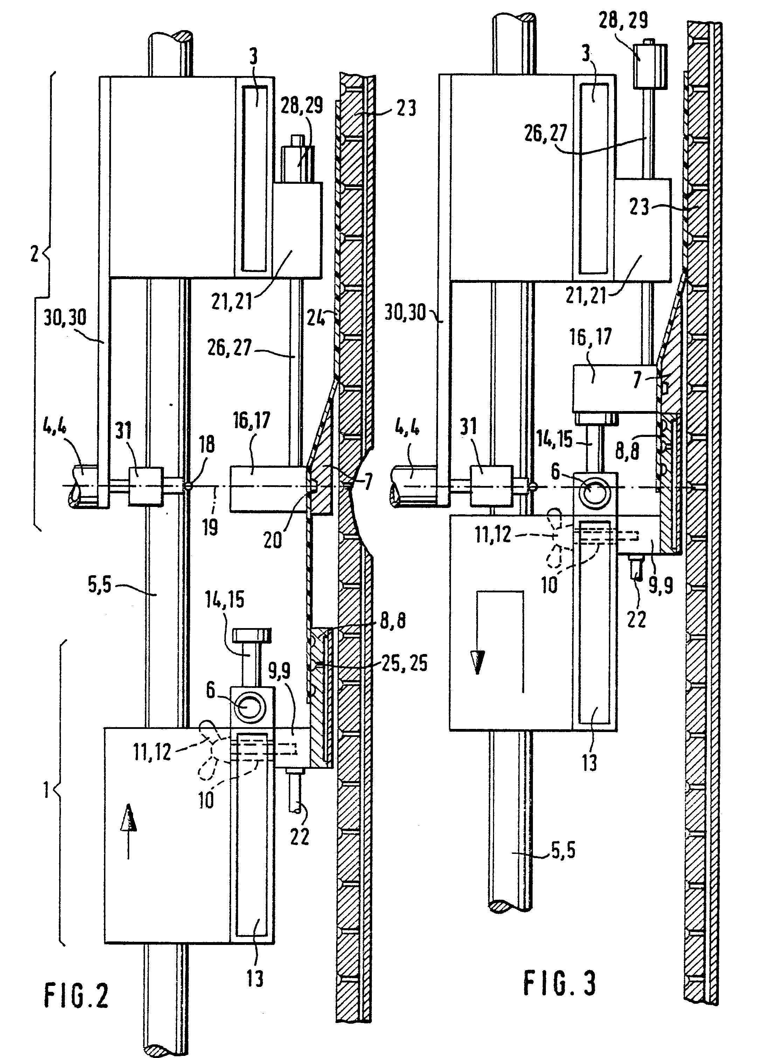

Fig. 1 zeigt eine perspektivische Ansicht eines Teils einer Greifereinrichtung 1, die zumindest zwei Vakuumgreifer 8,8 aufweist, die entlang einer Querstrebe 13 der Greifereinrichtung horizontal verschiebbar und mit Hilfe von Flügelschrauben 11 und 12, Rändelschrauben o. dgl. festlegbar sind. Die Vakuumgreifer 8,8 bilden zusammen mit der Querstrebe 13 die sogenannte Greiferleiste zum Festhalten und Transportieren eines zu schneidenden Materials, beispielsweise eines Fotoresistfilms 24, der in den Figuren 2 und 3 dargestellt ist, nicht jedoch aus Gründen der besseren Übersichtlichkeit in Fig. 1.

Die Greifereinrichtung 1 ist entlang vertikaler Führungsstangen 5,5 auf und ab verfahrbar, wie dies beispielsweise im einzelnen in der deutschen Patentanmeldung P 34 20 429.6 beschrieben ist.

Die Vakuumgreifer 8,8 sind auf der Seite, die der Rückseite des Fotoresistfilms 24 zugewandt ist, mit Formbohrungen 25,25 ausgestattet, die zum Festhalten des Fotoresistfilms 24 mit Vakuum beaufschlagt werden. Die Formbohrungen 25,25 sind zeilen-und reihenweise angeordnet und mit scharweise zueinander parallelen Nuten verbunden. Der tiefste Punkt jeder Formbohrung ist über eine nicht gezeigte Bohrung mit einer Vakuumleitung zu einer Vakuumpumpe verbunden. Die einzelne Formbohrung ist zentral in dem oben beschriebenen Nutensystem angeordnet und wird von quadratischen Flächenabschnitten eingeschlossen, die die Auflageflächen für den Fotoresistfilm 24 bilden und ein Einziehen des Fotoresistfilms in das Nutensystem ·verhindern. Dadurch ist sichergestellt, daß die Ansaugfläche für den Fotoresistfilm gleich der Fläche des Vakuumgreifers 8 ist, die von den äußeren Nuten des Nutensystems eingeschlossen wird.

Die Querstrebe 13 weist einen waagerechten Schlitz 10 auf, durch den sich die Flügelschrauben 11 und 12 o. dgl. erstrecken, die mit Befestigungselementen 9,9 (vgl. Fig.2 und 3) im Eingriff sind, an denen die Vakuumgreifer 8,8 befestigt sind. Durch Lösen der Muttern der Flügelschrauben 11 und 12 o. dgl. können diese in dem Schlitz 10 aufeinander zu bzw. voneinander weg verschoben werden und dadurch kann der Abstand der mit den Flügelschrauben 11 und 12 o. dgl. verbundenen Vakuumgreifer 8,8 voneinander frei gewählt werden, um die Positionen der Vakuumgreifer an die jeweilige Breite des zu verarbeitenden Fotoresistfilms 24 anzupassen. Obwohl dies im einzelnen nicht gezeigt ist, können auch mehr als zwei Vakuumgreifer 8,8 vorgesehen werden, beispielsweise drei oder vier derartige Vakuumgreifer, wobei deren Anzahl entsprechend der Breite des zu verarbeitenden Fotoresistfilms 24 gewählt wird.

Oberhalb der Querstrebe 13 erstreckt sich über die Breite der Querstrebe ein Blasrohr 6, dessen Öffnungen auf die Vakuumgreifer 8,8 gerichtet sind. Außerhalb des Blasrohrs 6, jedoch in Nähe der Stirnflächen des Blasrohrs, sind Anschlagschrauben 14 und 15 angeordnet, deren Funktion später noch näher beschrieben werden wird.

Fig. 2 zeigt eine Seitenansicht im Schnitt der Greifereinrichtung 1 und der Schneideinrichtung 2, wobei die Greifereinrichtung ihre untere Position einnimmt. Der Pfeil in Fig. 2 zeigt die Richtung an, in welche die Greifereinrichtung 1 entlang der Führungsstangen 5,5 verfahren wird. Oberhalb der Querstrebe 13 befindet sich das Blasrohr 6, oberhalb von dem eine der Anschlagschrauben 14' bzw. 15 zu erkennen ist. Eine der Flügelschrauben 11 bzw. 12 ist mit ihrer Flügelmutter gestrichelt angedeutet, die durch den verdeckten Schlitz hindurchgeführt ist und mit dem zugehörigen Befestigungselement 9 im Eingriff steht. An dem Befestigungselement 9 ist jeweils einer der Vakuumgreifer 8,8 angebracht, dessen Formbohrungen 25 von der Saugplatte 23 abgewandt sind.

Oberhalb und im Abstand zu der Greifereinrichtung 1 ist die Schneideinrichtung 2 lagefest an der Traverse 3 angebracht, die beispielsweise aus einem Vierkantrohr besteht. Dieses Vierkantrohr verbindet in nicht dargestellter Weise Führungen miteinander, die entlang der Führungsstangen 5,5 vertikal verschiebbar und in einer vorgegebenen Position festlegbar sind. An der Traverse 3 sind zwei Vertikalstreben 30,30 angebracht. An der Vorderseite dieser Vertikalstreben ist jeweils ein doppelt wirkender Führungszylinder 4 am unteren Ende befestigt. Die Kolbenstangen der horizontal ausgerichteten Führungszylinder 4,4 durchsetzen die Vertikalstreben 30,30 und sind in einem Vierkantrohr 31 gelagert, an dem ein beheizter Schneiddraht 18 befestigt ist, der in der Schnittansicht senkrecht zu Betrachtungsebene verläuft. Durch die Führungszylinder 4,4 wird der Schneiddraht 18 beim Ausfahren der Kolbenstangen der Führungszylinder in einer Schneidebene 19 hin und her verfahren.

Mit der Traverse 3 sind Linearführungen 21,21 verbunden, die Führungsbohrungen für Stangen 26,27 aufweisen, in denen die Stangen vertikal auf und ab gleiten können. An den unteren Enden der Stangen 26,27 sind Befestigungselemente 16,17 angebracht, an denen eine Schneidleiste 7 befestigt ist, die in der Schneidebene 19 eine Schneidnut 20 enthält. Der mittels der Führungszylinder 4,4 horizontal hin und her verschiebbare, beheizte Schneiddraht 18 der Schneideinrichtung 2 bewegt sich nach dem Durchschneiden des auf der Schneidleiste 7 aufliegenden Fotoresistfilms 24 in die Schneidnut 20 hinein und kurz danach aus dieser Schneidnut wieder heraus. An den oberen Enden der Stangen 26,27 sind Anschlagklötzchen 28,29 befestigt, die oberhalb der Linearführungen 21,21 liegen und die Abwärtsbewegung der Stangen 26,27 in den Linearführungen 21,21 begrenzen, da sie auf den oberen Stirnflächen der Linearführungen zur Anlage kommen.

Die Schneidleiste 7 ist nach oben hin und auf die Saugplatte 23 zu abgeschrägt, so daß der von oben her an der Saugplatte 23 anliegende Fotoresistfilm 24 durch die Schräge der Schneidleiste 7 von der Saugplattenoberfläche abgehoben wird. Die Befestigungselemente 16 und 17 erstrecken sich in horizontaler Richtung in die vertikale Bewegungsbahn der Greifereinrichtung 1, so daß beim vertikalen Hochfahren der Greifereinrichtung 1 die Anschlagschrauben 14 und 15 gegen die Unterseiten der Befestigungselemente 16 und 17 zum Anliegen kommen.

In Fig. 3 ist die Greifereinrichtung 1 in ihrer oberen Vertikalposition dargestellt, in der die Greifereinrichtung 1 mit ihren Anschlagschrauben 14 und 15 an der Unterseite der vertikal verschiebbaren Befestigungselemente 16 und 17 anliegt und diese beim Hochfahren mit hochgenommen hat. In dieser Stellung liegen auch die Vakuumgreifer 8,8 mit ihren Oberseiten an der Unterseite der Schneidleiste 7 an. Das Blasrohr 6 oberhalb der Querstrebe 13 befindet sich dann in der Schneidebene 19, so daß die aus dem Blasrohr 6 austretende Blasluft auf die Fotoresistschicht des Fotoresistfilms 24 auftrifft und diesen mit der Fotoresistfreien Rückseite gegen die Formbohrungen 25,25 der Vakuumgreifer 8,8 andrückt. Sobald die Vakuumgreifer mit Saugluft beaufschlagt werden, liegt der Fotoresistfilm 24 faltenfrei an den Vakuumgreifern 8,8 an, wird von diesen festgehalten und mit nach unten gezogen, in die in Fig. 2 gezeigte Lage. In der Schneidebene 19 erfolgt das Durchschneiden des Fotoresistfilms 24 mittels des beheizten Schneiddrahts 18. Der abgeschnittene Fotoresistfilm 24 schnappt während der weiteren Abwärtsbewegung der Vakuumgreifer 8,8 über die Kante der Schneidleiste 7 hinweg und legt sich an die Saugplatte 23 an, die unter Vakuum steht und den Fotoresistfilm 24 faltenfrei aufspannt.

In der unteren Endstellung der Greifereinrichtung 1 wird die Saugluft der Vakuumgreifer 8,8 abgeschaltet und die Greifereinrichtung 1 noch soweit abgesenkt, daß auch die Unterkante des Fotoresistfilms 24 an die Saugplatte 23 angesaugt werden kann. Sobald ein Schichtträger mit dem abgeschnittenen Fotoresistfilm 24 laminiert ist, wird die Greifereinrichtung 1 wieder hochgefahren und es beginnt ein neuer Festhalte-und Transportvorgang mit dem Fotoresistfilm 24.

Die mit den Bauteilen in Fig. 2 übereinstimmenden Bauteile in Fig. 3 werden zur Vermeidung von Wiederholungen nicht nochmals beschrieben.

**Ansprüche**

1. Greifereinrichtung in einer Laminiervorrichtung, mit einer verfahrbaren Greiferleiste zum Festhalten und Transportieren eines auf einen Schichtträger aufzulaminierenden Films, den eine Schneideinrichtung jeweils auf eine vorgegebene Länge zuschneidet, dadurch gekennzeichnet, daß die Greifereinrichtung (1) zumindest zwei Vakuumgreifer (8,8) aufweist, die entlang einer Querstrebe (13) der Greiferinrichtung horizontal verschiebbar und festlegbar sind, daß die Greifereinrichtung (1) entlang vertikaler Führungsstangen - (5,5) auf und ab verfahrbar ist und ein oberhalb der Querstrebe (13) sich über die Breite der Querstrebe erstreckendes Blasrohr (6) enthält, aus dessen Öffnungen ein Luftstrom in Richtung der Vakuumgreifer (8,8) austritt und daß auf der Oberseite des Blasrohrs (6), in der Nähe der Stirnflächen des Blasrohrs (6) Anschlagschrauben (14,15) angeordnet sind, die beim Hochfahren der Greifereinrichtung (1) an der Unterseite von vertikal verschiebbaren Befestigungselementen (16,17), an denen eine Schneidleiste - (7) befestigt ist, anliegen und diese beim Hochfahren der Greifereinrichtung (1) auf der fotoresistfreien Rückseite des Films mithochnehmen.

2. Greifereinrichtung nach Anspruch 1, dadurch gekennzeichnet, daß die Vakuumgreifer (8,8) Formbohrungen - (25,25), die mit Vakuum beaufschlagbar sind, auf der von einer Saugplatte (23) abgewandten Seite aufweisen und daß die der Saugplatte (23) zugewandte Seite der Vakuumgreifer (8,8) keine Formbohrungen hat und nahezu abstandslos an die Saugplatte (23) angrenzt.

3. Greifereinrichtung nach Anspruch 1, dadurch gekennzeichnet, daß die Schneidleiste (7) nach oben hin und auf die Saugplatte (23) zu abgeschrägt ist und daß der Film - (24) von oben her an der Saugplatte (23) und der abgeschrägten Schneidleiste (7) anliegt, die den Film von der Saugplatte (23) abhebt.

4. Greifereinrichtung nach Anspruch 1, dadurch gekennzeichnet, daß die Befestigungselemente (16,17), an denen die Schneidleiste (7) angebracht ist, an den unteren Enden von Stangen (26,27) befestigt sind, die in Linearführungen - (21,21) gleiten und daß die Linearführungen (21,21) mit einer Traverse (3) der lagefesten Schneideinrichtung (2) verbunden sind.

5. Greifereinrichtung nach Anspruch 4, dadurch gekennzeichnet, daß an den oberen Enden der Stangen (26,27) Anschlagklötzchen (28,29) befestigt sind, die sich oberhalb der Linearführungen (21,21) befinden und die Abwärtsbewegung der Stangen (26,27) in den Linearführungen (21,21) begrenzen.

6. Greifereinrichtung nach Anspruch 3, dadurch gekennzeichnet, daß die Schneidleiste (7) in einer Schneidebene - (19) eine Schneidnut (20) enthält, in die sich bzw. aus der sich ein in der Schneidebene (19) horizontal hin und her verschiebbarer, beheizter Schneiddraht (18) nach dem Durchschneiden des auf der Schneidleiste (7) aufliegenden Films (24) kurzfristig hinein und hinaus bewegt.

7. Greifereinrichtung nach Anspruch 1, dadurch gekennzeichnet, daß die Querstrebe (13) einen waagerechten Schlitz (10) aufweist, durch den sich Flügelschrauben - (11,12) erstrecken, die mit den Befestigungselementen - (9,9) im Eingriff sind, an denen die Vakuumgreifer (8,8) befestigt sind.

FIG.1

0 195 992

FIG.2

FIG.3